# EUROPÄISCHE PATENTSCHRIFT

(11) **EP 1 913 645 B1**
(45) Veröffentlichungstag und Bekanntmachung des Hinweises auf die Patenterteilung: **21.01.2009**
(21) Anmeldenummer: 06776713.7
(22) Anmeldetag: 09.08.2006
(51) Int. Cl.: H01L 31/117, H01L 31/118, H01L 31/08, H01L 27/146, G01T 1/24, G01T 1/29

(54) **RÖNTGENDETEKTORMODUL MIT KOLLIMATOR**
X-RAY DETECTOR MODULE WITH A COLLIMATOR
MODULE DE DÉTECTION DE RAYONS X À COLLIMATEUR

(30) Priorität: 10.08.2005 DE 102005037860
(43) Veröffentlichungstag der Anmeldung: 23.04.2008
(73) Patentinhaber: Deutsches Elektronen-Synchrotron DESY, 22603 Hamburg (DE)
(72) Erfinder: HANSEN, Karsten, 22549 Hamburg (DE); VENZMER, Alexander, 22767 Hamburg (DE)
(74) Vertreter: UEXKÜLL & STOLBERG
(86) Internationale Anmeldenummer: PCT/EP2006/007891
(87) Internationale Veröffentlichungsnummer: WO 2007/017272

(56) Entgegenhaltungen:
- EP-A- 1 400 984
- EP-A- 1 431 779
- WO-A-00/79598

## Beschreibung

Die vorliegende Erfindung betrifft ein Röntgendetektormodul mit einer Mehrzahl von Silizium-Driftdetektorzellen, die auf einem Sensorchip nebeneinanderliegend angeordnet sind, wobei der Sensorchip in einer Ausnehmung eines rahmenförmigen Grundträgers aufgenommen ist, so dass die sensitive Sensorchipoberfläche in der Öffnung des rahmenförmigen Grundträgers liegt.

Derartige Röntgendetektormodule werden z.B. in der Synchrotron-Röntgenfluoreszenzanalyse (SyRFA) und in der Röntgen-Feinstruktur-Spektroskopie (XAFS) eingesetzt. In beiden Fällen geht es hier um die Bestimmung der Energie einzelner Röntgenphotonen. In beiden Fällen stellen sich hohe Anforderungen an die Detektoren, die einerseits hohe Zählraten an Röntgenphotonen (größer 10⁵ s⁻¹) bei andererseits sehr guter Energieauflösung (<500 eV) detektieren sollen. Die Zählraten der Halbleiterdetektoren (HPGe, HPSi, Si(Li) etc. stoßen schon an Ablenkmagnetmessplätzen von Synchrotronstrahlungsquellen an ihre Grenzen.

Da der Feinstruktureffekt klein ist, müssen XAFS-Spektren mit hoher Datengüte gemessen werden. Für ein statistisches Rauschen kleiner 1% ist eine Zahl von Einträgen in der interessierenden Linie von größer als 10⁴ erforderlich. Für eine typische Messzeit von einer Sekunde ergibt sich daraus eine entsprechende Zählrate oberhalb von 10⁴ s⁻¹. In der Praxis ist sogar häufig eine um ein bis zwei Größenordnungen höhere Zählrate erforderlich, da die Amplitude der XAFS-Schwingungen mit zunehmendem Abstand von der Absorptionskante stark abnimmt und schließlich deutlich kleiner als 1% ist. Die geforderte Energieauflösung liegt bei wenigen Hundert eV (volle Breite auf halber Höhe). Diese Auflösung ist gerade ausreichend für die Trennung der K-Linien der 3d-Metalle. Für solche Anwendungen sind Silizium-Driftdetektoren vor Allem deswegen interessant, weil sie eine hohe Zählrate bei ausreichend guter Energieauflösung ermöglichen.

Für die Spurenanalytik mit der SyRFA sind eine hohe Quanteneffizienz des Detektors bei gleichzeitig großer Raumwinkelabdekkung, ein hohes Signal-zu-Untergrund-Verhältnis und eine möglichst gute Energieauflösung nötig.

Aus DE 199 29 567 A1 ist ein Röntgendetektormodul bekannt mit Ausnahme des Merkmals, daß der Sensorchip in eine Ausnehmung eines rahmenförmigen Grundträgers aufgenommen ist, so daß die sensitive Sensorchipoberfläche in der Öffnung des rahmenförmigen Grundträgers liegt, und des Merkmals, daß eine Maske zur Abschirmung von Röntgenphotonen auf der der Ausnehmung gegenüberliegenden Seite des Grundträgers befestigt ist. Ein entsprechendes Detektormodul ist beschrieben in "Thermal performance of a 61-cell Si-drift detector module with thermoelectric cooler", K. Hansen, Nuclear Instruments and Methods in Physics Research A517 (2004) 254-263. Bei diesem Detektormodul ist aus 61 sechseckigen Silizium-Driftdetektorzellen ein Detektorarray gebildet. Dieses Detektorarray liegt in einer Ausnehmung eines rahmenförmigen Grundträgers auf, so dass die sensitive Detektoroberfläche der Silizium-Driftdetektorzellen der Öffnung des rahmenförmigen Grundträgers zugewandt angeordnet sind. Auf der der sensitiven Detektoroberfläche gegenüberliegenden Seite des Detektorarrays folgen ein Leitungsverbindungsträger, ein Deckel, ein Strahlungsschild, sowie integrierte Schaltungen zur Vorverarbeitung der Signale der Silizium-Driftdetektorzellen. Obwohl ein solches Detektormodul hohe Zählraten verarbeiten kann und im Zentralbereich des Signals eine zufriedenstellende Energieauflösung hat, zeigt sich doch in den aufgenommenen Spektren ein nicht unerheblicher Un-tergrund von Ereignissen, die in weit auslaufenden Schwänzen weitgehend energieunabhängig verteilt sind. Mit anderen Worten ist das Signal-zu-Untergrund-Verhältnis bei dem bekannten Röntgendetektormodul nicht zufriedenstellend.

Aus EP 1 431 779 A1 ist ein Röntgendetektormodul bestehend aus einer Vielzahl von wabenförmig angeordneten, hexagonalen Driftdetektorzellen bekannt. Benachbarte Driftdetektorzellen sind dabei durch Barriereelektroden in Form von Stegen, die sich direkt auf der Oberfläche des Detektormoduls befinden, voneinander isoliert.

Es ist Aufgabe der vorliegenden Erfindung, ein kompaktes Röntgendetektormodul bereitzustellen, das neben der Detektierfähigkeit bei hohen Zählraten und einer guten Energieauflösung für Röntgenphotonen ein hohes Signal-zu-Untergrund-Verhältnis liefert.

Zur Lösung dieser Aufgabe dienen die kennzeichnenden Merkmale des Patentanspruchs 1 in Verbindung mit dessen Oberbegriff. Vorteilhafte Ausführungsformen der Erfindung sind in den Unteransprüchen angegeben.

Es ist vorgesehen, dass auf der den Silizium-Driftdetektorzellen gegenüberliegenden Seite des Grundträgers eine Maske aufgebracht ist, die mit Stegen über die Öffnung des Grundträgers ragt, wobei das Stegmuster dem Verlauf der Grenzstreifen benachbarter Silizium-Driftdetektorzellen folgt. Ferner deckt die Maske die Außenrandbereich der außen liegenden Siliziumdriftdetektor-Zellen ab. Die Maske ist dazu ausgestaltet, um die Grenzstreifen und Außenrandbereiche der äußeren Silizium-Driftdetektorzellen abzudecken und gegen einfallende Röntgenphotonen abzuschirmen.

Durch die Anbringung an dem Grundträger liegt die Maske direkt oberhalb der Silizium-Driftdetektorzellen in der Öffnung des Grundträgers, d.h. die Stege liegen direkt oberhalb über den Randstreifen aneinandergrenzender Silizium-Driftdetektorzellen. Diese Lage ist für die Abschirmfunktion der Stege wichtig, da mit dem vorliegenden Röntgendetektormodul auch Röntgenphotonenquellen aus unmittelbarer Nähe untersucht werden sollen. Da dann Röntgenphotonen aus einem erheblichen Einfallswinkelbereich auf die Detektorfläche treffen können, muss verhindert werden, dass Röntgenphotonen unter einem Winkel seitlich an den Stegen vorbei in einen Randbereich einer Siliziumdriftdetekor-Zelle treffen können.

Dabei sollte das Material und die Dicke der Maske so gewählt sein, dass wenigstens 90% aller einfallenden Röntgenphotonen der interessierenden Energie in dem Maskenmaterial absorbiert werden. Vorzugsweise sollten wenigstens 99% aller einfallenden Röntgenphotonen für eine hinreichende Abschirmung absorbiert werden; das bedeutet, dass das Produkt des Absorptionskoeffizienten µ und der Dicke d der Maske wenigstens 4,8 betragen sollte, so dass gemäß e^{-µd} die gewünschte Absorption erreicht wird.

Durch diese Maske wird verhindert, dass Ereignisse, die von Röntgenphotonen verursacht würden, die in den Randbereich einer Siliziumdetektordrift-Zelle einfallen, unterdrückt werden. Durch Abfangen von Röntgenphotonen, die in den Randbereich einer Silizium-Driftdetektorzelle treffen würden, wird die Aufnahme von Ereignissen verhindert, bei denen fast keine Korrelation mehr zwischen dem Messsignal der Silizium-Driftdetektorzelle und der Energie des Röntgenphotons vorhanden ist. Bei Treffern im Randbereich einer Zelle kann nämlich praktisch das gesamte Spektrum möglicher Messignale auftreten, von einem Messsignal nahe 0 bis zu einem Messsignal, das einer vollständig absorbierten Röntgenphotonenergie entspricht. Solche Treffer im Randbereich führen daher zu einem im Wesentlichen energieunabhängigen Untergrundspektrum.

Es hat sich gezeigt, dass bereits relativ schmale Stege, d.h. die Abdeckung des sehr schmalen Grenzstreifens benachbarter Silizium-Driftdetektorzellen genügt, um den nahezu energieunabhängigen Untergrund durch schlecht gemessene Ereignisse zu unterdrücken. Für diese Zwecke reicht bereits eine Breite im Bereich von 30 bis 300 µm, vorzugsweise im Bereich von 75 bis 250 µm, besonders bevorzugt im Bereich von 125 bis 175 µm. Durch derart schmale Stege über den Grenzstreifen benachbarter Silizium-Driftdetektorzellen wird die sensitive Detektorfläche nur in einem vertretbaren Maß reduziert. Um etwa die halben Strecken kann die Maske über den Außenrand des sensitiven Bereichs der außenliegenden Silizium-Driftdetektorzellen überstehen. Die Stege können entlang ihrer Länge in der Breite variieren. Entscheidend ist, dass die Grenzbereiche nebeneinanderliegender Zellen, in denen nur eine unzureichende Energierekonstruktion möglich ist, abgedeckt werden. Die Grenzstreifen haben nicht notwendig eine konstante Breite, denn aufgrund der Feldverteilung in den Driftdektektorzellen haben die abzudeckenden Grenzstreifen nicht notwendig eine gerade Grenzlinie.

Es ist weiter bevorzugt, auch Stege in dem Maskenmuster vorzusehen, die Leiterbahnen und Transistoren in den darunterliegenden Silizium-Driftdetektorzellen abdecken, um sie gegenüber einfallenden Röntgenphotonen abzuschirmen. Dadurch wird eine weitere Unterdrückung von potentiell sehr schlecht gemessenen Ereignissen bewirkt, die sich als energieunabhängiger Untergrund auswirken würden.

Um für einen möglichst kompakten Aufbau des Detektormoduls zu sorgen, insbesondere eine möglichst geringe Ausdehnung über die sensitive Detektorfläche hinaus, ist es vorteilhaft, die Zu- und Ableitungen zu dem Sensorchip durch metallische Leiterbahnen auf dem Grundträger zu bilden und, wo notwendig, Metallbahnen von der Vorderseite mit den gewünschten Metallbahnen auf der Rückseite des Grundträgers durch Durchkontaktierungen, d.h. hindurchgehenden Öffnungen, die Leitermaterial enthalten, zu realisieren.

Im Hinblick auf die Materialien zur Herstellung der Maske ist Folgendes zu berücksichtigen. Die Nachweisbarkeit des Phosphors bedingt idealerweise den Einsatz eines Maskenmaterials mit niedrigerer Ordnungszahl als Phosphor (z.B. Al). Allerdings ist das Absorptionsvermögen solcher Materialien bei höheren Energien so gering, so dass große Stegdicken in Einfallrichtung der Röntgenphotonen notwendig wären. Der Nachteil schwerer Elemente besteht darin, dass die von ihnen ausgehende parasitäre Fluoreszenz den Detektor erreichen und damit die Messung verfälschen würde. Deshalb kann es im Prinzip vorgesehen sein, verschiedene Masken für verschiedene vorgesehene Energiebereiche vorzusehen und je nach Bedarf zu montieren. Für Energien < 4,9 keV ist beispielsweise Titan als Maskenmaterial geeignet, für Energien zwischen etwa 2,7 keV und 17,9 keV ist Zirkonium gut geeignet, und im Bereich von 7,4 keV bis 48,5 keV ist Europium (oder schwerere Lantanidenelemente) geeignet.

Vorzugsweise sind die zur Auslese und zur Verstärkung der Signale der Silizium-Driftdetektorzellen vorgesehenen Schaltungen auf einem Schaltungs-Chip integriert. Der Schaltungs-Chip ist auf einem Ende eines länglichen, flexiblen Leiterbahnträgers befestigt, der die benötigten Leiterbahnen enthält, die mit den zugehörigen Anschlüssen an dem Chip verbunden sind. Der flexible Leiterbahnträger ist im Bereich des Chips auf der dem Chip gegenüberliegenden Seite durch Befestigung auf einem starren Schaltungsträger stabilisiert. Durch diese Anordnung kann der flexible Leiterbahnträger im Bereich jenseits des starren Schaltungsträgers im Bogen geführt werden, um eine flexible und raumsparende Führung des Leiterbahnträgers zu ermöglichen. Andererseits ist durch den starren Schaltungsträger eine ausreichende Stabilität gewährleistet. Ein wesentlicher Vorteil dieser Anordnung besteht darin, dass der Leiterbahnträger über seine ganze Länge, d.h. von den Anschlusspunkten, an die die Anschlüsse des Schaltungs-Chips angeschlossenen sind, bis zum Ende, bei dem eine Überführung in ein Kabel vorgesehen ist, "in einem Stück" ausgeführt werden kann, d.h. außer dem Verbindungsanschluss zu dem Schaltungs-Chip, der durch Drahtbonden des Anschlusses an dem Schaltungs-Chip an einen Anschlusspunkt auf dem Leiterbahnträger realisiert werden kann, wird keine weitere gesonderte elektrische Verbindung mehr benötigt.

Der Leiterbahnträger kann z.B. aus einer Vielzahl von übereinandergeschichteten Folien gebildet sein, wobei jede Folie jeweils eine Mehrzahl von Leiterbahnen auf ihrer Oberfläche trägt. Auf diese Weise wird ein flexibler Leiterbahnträger mit einer Vielzahl von Leiterbahnebenen realisiert. Dadurch lässt sich eine große Zahl von Leiterbahnen in einem Leiterbahnträger mit relativ geringen Querschnittsabmessungen unterbringen.

Um von dem Leiterbahnträger einen Übergang zu einem Kabel zu ermöglichen, ist es vorteilhaft, den Leiterbahnträger an seinem von dem Schaltungs-Chip entfernten Ende mit einem Aufweitungsbereich größerer Breite zu versehen. Auf dieser vergrößerten Fläche ist es dann möglich, aufgefächert eine Vielzahl von Kontaktflächen unterzubringen, wobei jede Kontaktfläche einer Leiterbahn zugeordnet ist, die in der zugehörigen Kontakfläche endet. Durch diese Aufweitung wird der zur Verfügung stehende Raum zum Anschließen der Leiterbahnen an die Adern eines Kabels deutlich vergrößert, was die Herstellung der Verbindungen vereinfacht und ihre Fehleranfälligkeit vermindert, da für die Verbindungen mehr Platz zur Verfügung steht.

Der Aufweitungsbereich des Leiterbahnträgers kann in einer vorteilhaften Ausführungsform in Röhrenform gebogen sein, um so die durch die Aufweitung des Leiterbahnträgers verursachte vergrößerte Breitenausdehnung wieder zu reduzieren.

In einer bevorzugten Ausführungsform kann das Röntgendetektormodul in einem Sensorkopf aufeinanderfolgend hintereinander die Maske, der Grundträger, der Sensorchip, der Deckel mit einer Strahlungsabschirmung, der Schaltungsträger und der Schaltungs-Chip angeordnet sein, wobei die Querschnittsform des Sensorkopfes im Wesentlichen mit der Außenkontur des Grundträgers übereinstimmt, wobei der Sensorkopf an einem Kühlrohr mit wiederum im Wesentlichen gleicher Querschnittsform angebracht ist. Der röhrenförmig gebogene Aufweitungsbereich des Leiterbahnträgers kann an der Innenwand des Kühlrohrs anliegen.

Zwischen Sensorkopf und Kühlrohr kann ein Zwischenstück mit einem Peltier-Element zur Kühlung eingebaut sein. Das Kühlrohr selbst dient zur Wärmeableitung, es besteht also vorzugsweise aus einem Material mit guter Wärmeleitfähigkeit. In bestimmten Anwendungen ist es erforderlich, dass das Kühlrohr aktiv gekühlt wird, z.B. wenn das Röntgendetektormodul im Vakuum angeordnet ist und daher eine Wärmeabfuhr durch Konvektion in die Umgebungsluft nicht möglich ist.

Durch den Aufbau des Röntgendetektormoduls, der auf ganzer Länge im Querschnitt im Wesentlichen mit der Außenkontur des Grundträgers übereinstimmt, wird ein sehr kompakter Aufbau realisiert, der es darüber hinaus ermöglicht, mehrere derartiger Röntgendetektormodule nebeneinander anzuordnen, so dass die Grundträger benachbarter Röntgendetektormodule direkt aneinanderliegen, wodurch der Totraum zwischen benachbarten Röntgendetektormodulen minimiert wird.

In einer vorteilhaften Ausführungsform weist jedes Modul einen Sensorchip mit 7 Silizium-Driftdetektorzellen auf, die jeweils die Form eines gleichseitigen Sechsecks haben, wobei eine zentrale Zelle von sechs Zellen mit gleicher Außenform umgeben ist. Der Grundträger hat vorzugsweise ebenfalls die Außenform eines gleichseitigen Sechsecks, das geringfügig über den Außenrand des Sensorchips hinaussteht. Durch diese sechseckige Ausbildung können mehrere Detektormodule mit ihren Grundträgern in direkte Anlage aneinander wiederum mit einem zentralen Röntgendetektormodul und sechs darum herum angeordneten Röntgendetektormodulen zusammengestellt werden. Bei Bedarf kann die Anordnung beliebig erweitert werden.

Die Erfindung wird im Folgenden anhand eines Ausführungsbeispiels in den Zeichnungen erläutert, in denen:
- Figur 1: eine schematische Draufsicht auf den Grundträger mit eingelegtem Sensorchip zeigt;
- Figur 2: eine schematische Draufsicht auf die Maske und die darunterliegende sensitive Oberfläche des Sensorchips und die des umgebenden Grundträger zeigt;
- Figur 3: eine Querschnittsansicht des Sensorkopfes zeigt;
- Figur 4: eine perspektivische Explosionsdarstellung der Komponenten des Detektormoduls und des zusammengesetzten Röntgendetektormoduls zeigt;
- Figur 5: eine perspektivische Detailansicht des vorderen Ende des Röntgendetektormoduls von zwei Seiten aus zeigt; und
- Figur 6: eine Draufsicht auf den Leiterbahnträger in flach liegendem Zustand zeigt.

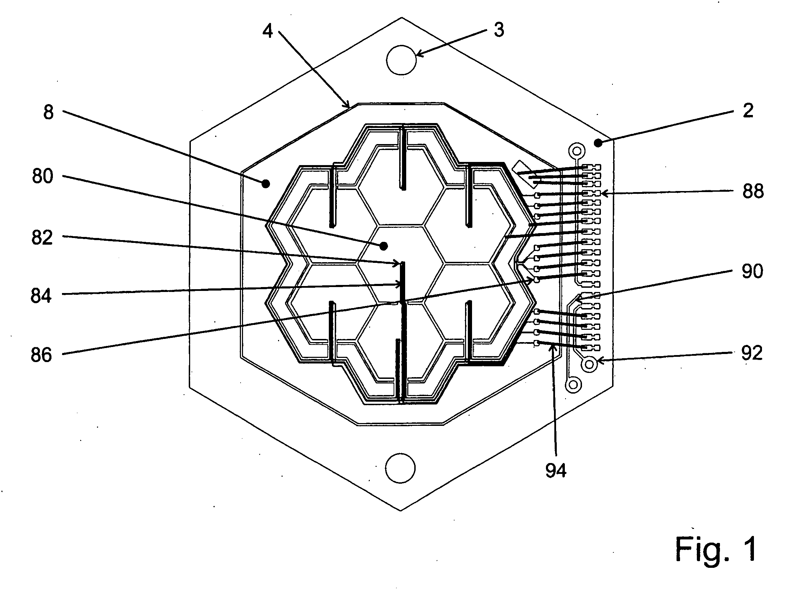

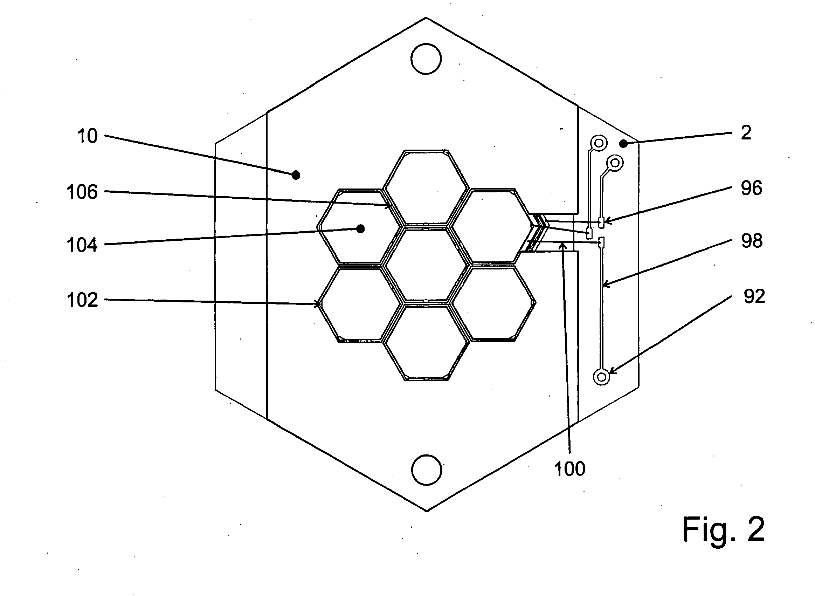

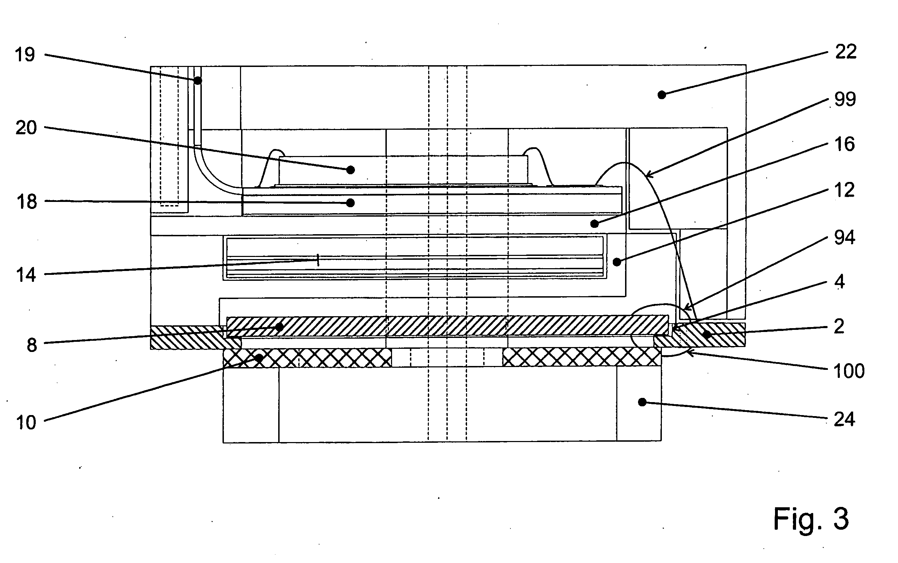

Figur 1 zeigt eine Draufsicht auf den Grundträger 2 mit eingelegtem Sensorchip 8 in Draufsicht aus der Richtung der restlichen Komponenten des Röntgendetektormoduls. Figur 2 zeigt die Draufsicht auf die andere Seite des Grundträgers 2, wobei die sensitiven Detektorzellen durch die Öffnung des rahmenförmigen Grundträgers 2 und die Maske 10 zu sehen ist. Der Sensorchip 8 ist ist passgenau in der Ausnehmung 4 (siehe Figur 3) des Grundträgers 2 aufgenommen, wodurch eine genaue Positionierung des Sensorchips 8 in dem Aufbau gewährleistet werden kann.

Die Maske 10 ist mit Stegen 106 versehen, die in Öffnung des rahmenförmigen Grundträgers 2 hineinragen und über den Sensorchip 8 verlaufen. Ihr Verlauf ist so gestaltet, dass sie die Grenzstreifen aneinandergrenzender benachbarter Silizium-Driftdetektorzellen 80 abdecken. Die Außenkontur der Öffnung der Maske 10 ist so geformt, dass die Außenrandbereiche der außen liegenden Silizium-Driftdetektorzellen von ihr abgedeckt werden, so dass zusammen mit den Stegen 106 definierte Eintrittsfenster 104 gebildet sind hinter denen jeweils eine Silizium-Driftdetektorzelle liegt, deren Außenrandbereiche durch die Maske 10 abgedeckt werden. Die Metallisierung des Sensorchips ist durch das Bezugszeichen 104 angedeutet.

Die Dicke der Maskenlage 10 ist so gewählt, dass für ein gegebenes Material der Maske eine möglichst weitgehende Absorption von Röntgenphotonen in dem interessierenden Bereich erreicht wird. Bei einem interessierenden Energiebereich von 2 keV bis 35 keV kann z.B. eine Maske aus Zirkonium mit einer Schichtdicke von 490 µm vorgesehen sein. Die Stegbreite, die bei senkrechtem Einfall der Breite des abgedeckten Grenzstreifens benachbarter Silizium-Driftdetektorzellen entspricht, kann vorzugsweise im Bereich von 125 bis 175 µm liegen. Damit wird eine ausreichende Abschirmung des Grenzstreifens erreicht, in dem die Absorption von Röntgenphotonen zu Messergebnissen mit sehr schlechter Korrelation zur Röntgenphotonen-Energie ergeben würde. Andererseits ist die durch die schmalen Stege abgedeckte Detektorfläche im Verhältnis relativ gering, so dass die sensitive Oberfläche insgesamt nur in einem vertretbaren Maße reduziert wird.

Der vorgesehene Aufbau, der auch in der Schnittdarstellung von Figur 3 zu sehen ist, nämlich die Anbringung der Maske an der der Ausnehmung 4 gegenüberliegenden Seite des Grundträgers 2 führt dazu, dass die Maske 10 und ihre Stege unmittelbar über den durch sie abzudeckenden Gebieten liegen. Diese räumlich nahe Anordnung der Maske über dem Sensorchip ist für Anwendungen wichtig, bei denen das Röntgendetektormodul sehr nahe an die Röntgenquelle gebracht wird. Bei solchen Anwendungen wird durch den Sensorchip 8 ein relativ großer Bereich von Einfallswinkeln von Röntgenphotonen abgedeckt. Eine zuverlässige Abschirmung von Röntgenphotonen in den Grenzbereichen benachbarter Zellen lässt sich dann nur erreichen, wenn die Abschirmstege sehr nahe oberhalb der Oberfläche der Silizium-Driftdetektorzellen liegen.

Im Folgenden wird die elektrische Verbindung des Sensorchips 8, zunächst unter Bezugnahme auf die Figuren 1 bis 3, beschrieben. In den Sensorchip 8 sind Leiterbahnen 84 ingegriert, die zur elektrischen Versorgung und zur Ableitung Messsignalen dienen. Diese Leiterbahnen 84 (Figur 1) sind an einer Seite des achteckigen Sensorchips 8 zusammengeführt und enden dort jeweils in einem sogenannten Bondpad 86, d.h. einer kleinen Kontaktfläche. Jedes Bondpad 86 ist durch einen Bonddraht 94 mit einem zugeordneten Bondpad 88 auf dem Grundträger 2 verbunden.

Auf der gegenüberliegenden Seite (Figur 2) führen ebenfalls Bonddrähte 100 jeweils zu Bondpads 96. Die davon ausgehenden Leiterbahnen 98 führen jeweils zu einer Durchkontaktierung 92, d.h. einer hindurchgehenden Öffnung, die Leitermaterial enthält. Durch diese Durchkontaktierungen 92 werden die Leiterbahnen 98 mit zugehörigen Leiterbahnen 90 auf der gegenüberliegenden Seite (Figur 1) verbunden. Diese elektrische Verbindung mittels Durchkontaktierungen ist einerseits räumlich sehr kompakt und andererseits wenig fehler- oder störanfällig. Die Leiterbahnen 84, 90 und 98 sind vorzugsweise in Dünnschichttechnik auf dem Grundträger 2 aufgebrachte Leiterbahnen.

Von der in Figur 1 zu sehenden Sammelstelle der elektrischen Anschlüsse, nämlich die Reihe der Bondpads 88, erfolgt nun die weitere elektrische Verbindung zu einem Schaltungs-Chip 20, der die zur Versorgung des Sensorchips 8 und zur Aufbereitung der Signale der Silizium-Driftdetektorzellen verwendeten Schaltungen (z.B. Vorverstärker) enthält. Wie in Figur 3 gezeigt, erfolgt diese elektrische Verbindung durch Bonddrähte 99, die zu Kontaktpunkten auf einem Leiterbahnträger 19 führen, auf dem der Schaltungs-Chip 20 befestigt ist. Der Leiterbahnträger 19 ist ein längliches, flexibles und flaches bahnförmiges Teil, das eine Vielzahl von dadurch hindurchlaufenden Leiterbahnen enthält. Ein solcher Leiterbahnträger 19 kann z.B. aus einer Vielzahl übereinandergeschichteter Folien bestehen, die jeweils eine Mehrzahl von Leiterbahnen auf ihrer Oberfläche tragen, so dass eine Vielzahl von Leiterbahnebenen in dem Leiterbahnträger 19 gebildet ist. Zur Stabilisierung ist der Leiterbahnträger im Bereich des Schaltungs-Chips 20 auf einen festen Schaltungsträger 18 befestigt.

Die von dem Schaltungs-Chip 20 ausgehenden Leitungen sind jeweils über einen Bonddraht mit einem Kontaktpunkt auf dem flexiblen Leiterbahnträger 19 und dadurch mit einer von dessen Leiterbahnen verbunden. Im Bereich jenseits des Schaltungsträgers 18 ist der flexible Leiterbahnträger dann im Bogen gekrümmt geführt, wie in Figur 3 gezeigt.

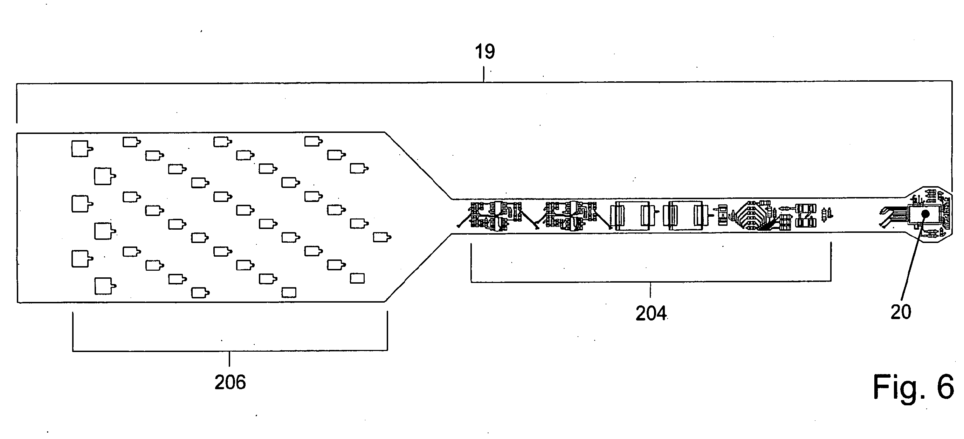

Eine schematische Draufsicht auf den Leiterbahnträger 19 ist in Figur 6 gezeigt. An seinem einen Ende trägt der Leiterbahnträger 19 den darauf befestigten Schaltungs-Chip 20, wobei der Leiterbahnträger 19 in diesem Bereich durch einen auf der dem Schaltungs-Chip gegenüberliegenden Seite befestigten festen Schaltungsträger 18 stabilisiert ist. Dieser Aufbau, nämlich die Befestigung des Schaltungs-Chips 20 auf dem Leiterbahnträger 19 selbst, ermöglicht es, die Leiterbahnen ausgehend von ihrer Verbindung mit den Kontaktpunkten am Schaltungs-Chip 20 in einem Stück auszuführen, d.h. ohne weitere Verbindungen durch Bonddrähte. Im Stand der Technik wurde der Schaltungs-Chip dagegen direkt auf einem Schaltungsträger gehalten und der Leiterbahnträger begann dann außerhalb des Aufbaus von Schaltungsträger und Schaltungs-Chip. Dadurch wurde eine weitere elektrische Verbindung durch Bonddrähte benötigt.

Durch die flexible Gestaltung des Leiterbahnträgers 19 kann dieser dann im Bereich außerhalb des starren Schaltungsträgers 18 im Bogen gekrümmt weggeführt werden. Entfernt von dem für die Krümmung des Leiterbahnträgers vorgesehenen Bereich sind auf dem Leiterbahnträger 19 eine Vielzahl von elektrischen Schaltungen 204 vorgesehen, die zur weiteren Aufbereitung der elektrischen Detektorzellensignale für deren Weiterleitung vorgesehen sind. Dabei handelt es sich insbesondere um Treiberschaltungen, die die Übertragbarkeit der Signale auf den folgenden Leitungen verbessern. Diese Anordnung der Schaltungen 204 entfernt von dem Schaltungs-Chip 20 und dem Sensorchip 8 hat den Vorteil, dass die für den Betrieb des Sensorchips 8 schädliche Abwärme der Schaltungen 204 sich auf den Sensorchip 8 nicht oder nur noch vernachlässigbar auswirken kann. Dagegen müssen die Schaltungen in dem Schaltungs-Chip 20 nahe an dem Sensorchip 8 angeordnet werden. Die Schaltungen, insbesondere die Vorverstärkerschaltungen, auf dem Schaltungs-Chip 20 müssen deswegen nahe an dem Sensorchip 8 liegen, da jede Verlängerung der Leitungswege vor den Vorverstärkern die Kapazitäten vor den Vorverstärkereingängen erhöht, was wiederum zu einem mit der Kapazität ansteigendem Rauschen und damit zu einer Verschlechterung der Auflösung führt. Die Abwärme des Schaltungs-Chips muss durch Kühlung abgeführt werden.

An den streifenförmigen Bereich des flexiblen Leitungsträgers 19 mit den elektrischen Schaltungen 204 schließt sich ein Aufweitungsbereich 206 an. Hier ist eine Vielzahl von Kontaktpads oder Kontaktflächen angeordnet, von denen jedes einer der Leiterbahnen des flexiblen Leiterbahnträgers 19 zugeordnet und damit verbunden ist. Der Aufweitungsbereich 206 ermöglicht es, diese Vielzahl von Kontaktpunkten soweit aufgefächert anzuordnen, dass es unter räumlichen Gesichtspunkten möglich ist, die Kontaktpads jeweils mit einer Ader eines Kabels zu verbinden. Durch die direkte Verbindung der Kontaktflächen mit den Adern eines Kabels wird eine steckerlose Kabelanbindung realisiert.

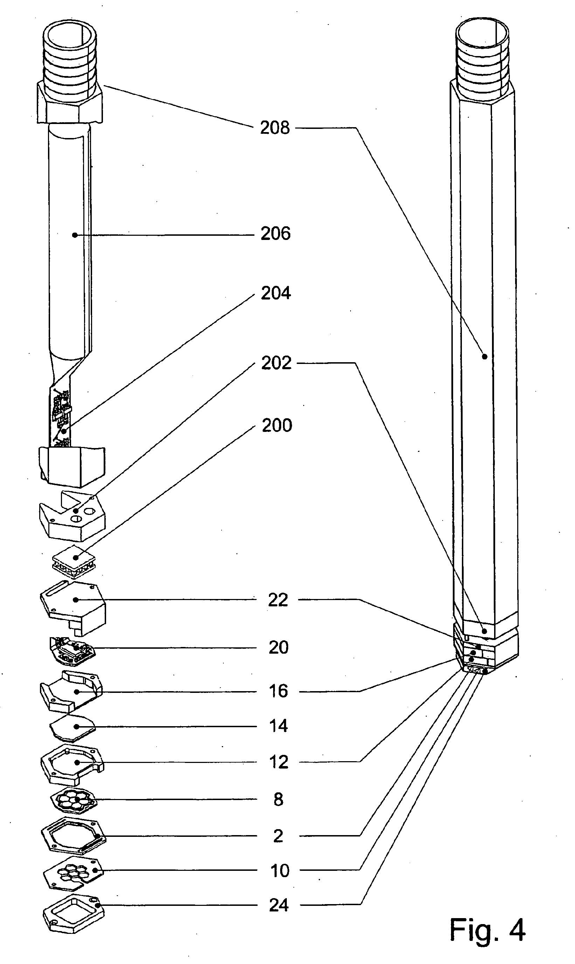

Um die seitliche Ausdehnung des Aufweitungsbereichs 206 zu reduzieren, kann dieser nach Herstellung der elektrischen Verbindungen an den Kontaktpads im Aufweitungsbereich 206 in Röhrenform gebogen werden, wie dies im linken Teil von Figur 4 dargestellt ist. So kann der Aufweitungsbereich 206 in Röhrenform in einem Kühlrohr 208 untergebracht werden.

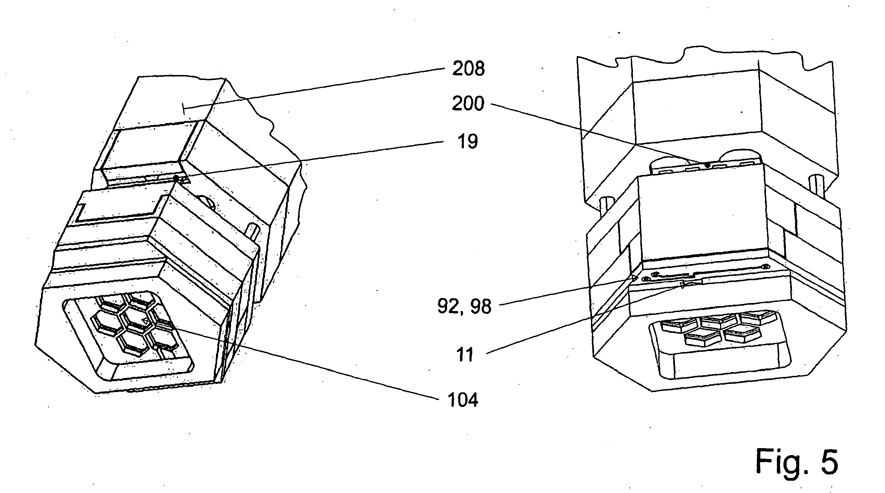

Anhand der Figuren 4 und 5 wird nun der komponentenmäßige Aufbau des Röntgendetektormoduls erläutert. Außen liegt eine Abdeckkappe 24, die zur Absorption von Ti-Rückfluoreszenz aus den Schrauben dient. An die Abdeckkappe 24 schließt sich die Maske 10 an. Die Maske 10 ist wiederum an dem Grundträger 2 angebracht, in den auf seine andere Seite der Sensorchip 8 in die Ausnehmung des Grundträgers eingelegt ist. Auf den Sensorchip 8 folgt ein erster Deckel 12, der an seiner vom Sensorchip 8 abgewandten Seite eine Ausnehmung hat, in die ein aus mehreren Schichten bestehende Strahlungsabschirmung 14 eingelegt ist. Darauf folgt ein zweiter Deckel 16, der wiederum an seiner vom Sensorchip 8 abgewandten Seite eine Ausnehmung hat, in die der Schaltungsträger 18 mit dem darauf befestigten flexiblen Leiterbahnträger 19 und dem darüber befestigten Schaltungs-Chip 20 eingelegt ist. Dieser Raum für den Schaltungs-Chip 20 wird von einem dritten Deckel 22 geschlossen, der an einer Seite einen Schlitz zur Durchführung des flexiblen Leiterbahnträgers 19 hat. Mit dem dritten Deckel 22 endet der eigentliche Sensorkopf.

Zwischen dem Sensorkopf und dem äußeren Kühlrohr 208 ist ein Zwischenstück gesetzt, das aus einem Peltier-Element 200 und einem Wärmespreizer 202 aufgebaut ist. Das Peltier-Element 200 dient zur Kühlung und Abführung der Wärme aus dem Schaltungs-Chip 20 und Sensorchip 8. Abgeführte Wärme verteilt sich über den Wärmespreizer in das Kühlrohr 208. Eine Kühlung des Kühlrohrs 208 ist, wenn es in Kontakt mit der Umgebungsluft ist, nicht unbedingt erforderlich, da es dann mit einer relativ großen Oberfläche in Wärmeaustausch mit der Umgebung steht und so Wärme abgeben kann.

Wie aus Figur 4 zu erkennen ist, haben alle Komponenten, die zusammengesetzt das Röntgendetektormodul ergeben, eine Querschnittsform, die der des Grundträgers 2 entspricht oder innerhalb dieser Querschnittsform liegt, d.h. in einer Projektion auf die Ebene des Grundträgers ragt kein Teil über die Außenkontur des Grundträgers 2 hinaus. Das zusammengesetzte Röntgendetektormodul hat dann auf seiner ganzen Länge eine Querschnittsform, die nicht über die des Grundträgers 2 hinaussteht. Dadurch ist es möglich, mehrere Röntgendetektormodule nebeneinanderliegend anzuordnen, wobei diese mit ihren Grundträgern 2 aneinanderstoßend zusammengesetzt werden können, so dass ein Feld aus mehreren Röntgendetektormodulen mit minimalem Totraum zwischen den Modulen zusammensetzbar ist. In der dargestellten bevorzugten Ausführungsform bilden der Sensorkopf mit dem Kühlrohr ein stiftartiges Gehäuse mit hexagonaler Außenform.

Die Strahlungsabschirmung 14 kann, wie in Figur 3 dargestellt, aus mehreren Schichten bestehen. Diese Strahlungsabschirmung 14 hat die Aufgabe, die Elektronik vor Strahlenschäden zu schützen. Gleichzeitig muss er so aufgebaut sein, dass die unvermeidlich angeregte Fluoreszenz nicht zu Verfälschungen der gemessenen Spektren bzw. ihrerseits zu Strahlenschäden der Elektronik führt. Die Strahlungsabschirmung kann z.B. aus Schichten aus Tantal, Titan und Aluminium bestehen, wobei das Tantal zum Schutz der Elektronik und die anderen Materialien zur Reduktion der Rückfluoreszenz auf den Sensorchip 8 dienen. Auf das Aluminium kann auch verzichtet werden, wenn der Deckel 12 z.B. aus Aluminiumnitrid hergestellt ist, so dass die Abschirmungswirkung des Aluminiums durch den Deckel 12 bewirkt werden kann.

## Patentansprüche

1. Röntgendetektormodul mit einer Mehrzahl von Silizium-Driftdetektorzellen, die auf einem Sensorchip nebeneinanderliegend angeordnet sind, wobei der Sensorchip in einer Ausnehmung eines rahmenförmigen Grundträgers aufgenommen ist, so dass die sensitive Sensorchipoberfläche in der Öffnung des rahmenförmigen Grundträgers liegt, wobei auf der der Ausnehmung gegenüberliegenden Seite des Grundträgers eine Maske (10) befestigt ist, die die Außenrandbereiche von außen liegenden Silizium-Driftdetektorzellen (80) abdeckt und mit Stegen (106) über den Sensorchip (8) in die Öffnung des Grundträgers (2) ragt, wobei die Stege so angeordnet sind, dass sie die Grenzstreifen benachbarter Silizium-Driftdetektorzellen (80) abdecken, um die durch die Maske (10) abgedeckten Außenrandbereiche und Grenzstreifen gegenüber einfallenden Röntgenphotonen abzuschirmen.

2. Röntgendetektormodul nach Anspruch 1, **dadurch gekennzeichnet, dass** die zur Versorgung und Auslese des Sensorchips (8) benötigen Leitungen durch Metallbahnen (90) auf der Vorder- und Rückseite des Grundträgers (2) gebildet sind, wobei benötigte Verbindungen zwischen Vorder- und Rückseite zwischen bestimmten Metallbahnen durch Durchkontaktierungen (92) des Grundträgers (2) gebildet sind.

3. Röntgendetektormodul nach Anspruch 1 oder 2, **dadurch gekennzeichnet, dass** das Substratmaterial des Grundträgers (2) aus Keramiken auf der Basis von Aluminium oder Beryllium, insbesondere Al₂O₃, AlN oder BeO₂, vorzugsweise AlN, gebildet ist.

4. Röntgendetektormodul nach Anspruch 2 oder 3, **dadurch gekennzeichnet, dass** die Metallbahnen (90) metallische Dünnschichtbahnen sind.

5. Röntgendetektormodul nach einem der vorhergehenden Ansprüche, **dadurch gekennzeichnet, dass** weitere Stege in dem Maskenmuster vorgesehen sind, die Leiterbahnen (84) und Transistoren (82) in den darunterliegenden Silizium-Driftdetektorzellen (80) abdecken, um sie gegenüber einfallenden Röntgenphotonen abzuschirmen.

6. Röntgendetektormodul nach einem der vorhergehenden Ansprüche, **dadurch gekennzeichnet, dass** das Maskenmaterial Zirkonium, Titan, Aluminium und/oder Europium aufweist.

7. Röntgendetektormodul nach Anspruch 6, **dadurch gekennzeichnet, dass** das Maskenmaterial aus Zirkonium und/oder ZrO₂ besteht.

8. Röntgendetektormodul nach einem der vorhergehenden Ansprüche, **dadurch gekennzeichnet, dass** die Stege der Maske (10) eine Breite im Bereich von 30 bis 300 µm, vorzugsweise im Bereich von 75 bis 250 µm, insbesondere im Bereich von 125 bis 175 µm haben.

9. Röntgendetektormodul nach einem der vorhergehenden Ansprüche, **dadurch gekennzeichnet, dass** auf dem Grundträger (2) auf der Seite des Sensorchips (8) ein den Sensorchip abdeckender Deckel (12) befestigt ist, dessen von dem Sensorchip abgewandte Seite mit einer die Fläche des Sensorchips in der Projektion überdeckenden Ausnehmung versehen ist, in der ein scheibenförmiger Strahlungsabschirmungskörper (14) angeordnet ist.

10. Röntgendetektormodul nach Anspruch 9, **dadurch gekennzeichnet, dass** der Deckel (12) aus Al₂O₃ oder AlN, vorzugsweise aus AlN, hergestellt ist.

11. Röntgendetektormodul nach Anspruch 9 oder 10, **dadurch gekennzeichnet, dass** der Strahlungsabschirmungskörper (14) Tantal, Titan und optional Aluminium enthält.

12. Röntgendetektormodul nach einem der vorhergehenden Ansprüche, **dadurch gekennzeichnet, dass** die zur Auslese und Verstärkung der Signale der Silizium-Driftdetektorzellen (80) vorgesehenen Schaltungen auf einem Schaltungs-Chip (20) integriert sind, der auf einem Ende eines länglichen, flexiblen Leiterbahnträgers (19) befestigt ist, welcher die zur Zu- und Ableitung von elektrischen Signalen und Versorgungsspannungen vorgesehenen Leiterbahnen enthält, die mit den zugehörigen Anschlüssen an dem Chip verbunden sind, wobei der flexible Leiterbahnträger im Bereich des Chips (20) auf der dem Chip gegenüberliegenden Seite durch Befestigung auf einem starren Schaltungsträger (18) stabilisiert ist.

13. Röntgendetektormodul nach Anspruch 12, **dadurch gekennzeichnet, dass** der flexible Leiterbahnträger (19) aus einer Vielzahl übereinander geschichteter Folien gebildet sind, die jeweils eine Mehrzahl von Leiterbahnen auf ihrer Oberfläche tragen.

14. Röntgendetektormodul nach Anspruch 12 oder 13, **dadurch gekennzeichnet, dass** der Schaltungsträger (18) in einer Ebene parallel zur Ebene des Sensorchips (20) liegt und dass der Leiterbahnträger (19) im an den Schaltungsträger angrenzenden Bereich in einer Kurve von etwa 90° geführt ist, um in einer Richtung senkrecht zu den Ebenen des Sensorchips (20) und des Schaltungsträgers (18) von dem Letzteren fort zu führen.

15. Röntgendetektormodul nach einem der Ansprüche 12 bis 14, **dadurch gekennzeichnet, dass** Leitungstreiberschaltungen (204) entfernt von dem Sensorchip (8) und dem Schaltungs-Chip (20) auf dem Leiterbahnträger (19) angeordnet sind, um die in dem Schaltungs-Chip (20) vorverstärkten Signale der Silizium-Driftdetektorzellen (80) für die weitere Übertragung auf Leitungen aufzubereiten.

16. Röntgendetektormodul nach einem der Ansprüche 12 bis 15, **dadurch gekennzeichnet, dass** sich die Breite des länglichen Leiterbahnträgers entfernt von dem Schaltungs-Chip vergrößert und dass in dieser aufgeweiteten Fläche (206) verteilt eine Vielzahl von Kontaktflächen vorgesehen ist, von denen jede einer Leiterbahn des Leiterbahnträgers zugeordnet und mit ihr verbunden ist, wobei die kontaktflächen jeweils mit einer Leiterbahn und mit einer Ader verbunden sind, wobei die Ader in ein Kabel führt.

17. Röntgendetektormodul nach Anspruch 16, **dadurch gekennzeichnet, dass** die Adern eines Kabels direkt mit Kontaktflächen in dem Aufweitungsbereich (206) des Leiterbahnträgers (19) verbunden sind, um so eine steckerlose Kabelanbindung zu schaffen.

18. Röntgendetektormodul nach Anspruch 16 oder 17, **dadurch gekennzeichnet, dass** der Leiterbahnträger (19) im Aufweitungsbereich (206) röhrenförmig gebogen ist, um seine durch die Aufweitung verursachte vergrößerte Breitenausdehnung zu reduzieren.

19. Röntgendetektormodul nach einem der vorhergehenden Ansprüche, **dadurch gekennzeichnet, dass** aufeinanderfolgend hintereinander Maske (10), Grundträger (2), Sensorchip (8), Deckel (12), Strahlungsschild (14), Schaltungsträger (18), Leiterbahnträger (19) und Schaltungs-Chip (20) als Sensorkopf montiert sind, wobei die Querschnittsform des Sensorkopfes der Außenkontur des Grundträgers (2) entspricht, wobei der Sensorkopf an einem Kühlrohr (208) mit gleicher Querschnittsform angebracht ist.

20. Röntgendetektormodul nach Ansprüchen 18 und 19, **dadurch gekennzeichnet, dass** der röhrenförmig gebogene Aufweitungsbereich (206) des Leiterbahnträgers an der Innenwand des Kühlrohrs (208) anliegt.

21. Röntgendetektormodul nach Anspruch 19 oder 20, **dadurch gekennzeichnet, dass** zwischen Sensorkopf und Kühlrohr (208) ein Zwischenstück mit einem Peltier-Element (200) zur Kühlung eingebaut ist.

22. Röntgendetektormodul nach einem der vorhergehenden Ansprüche, **dadurch gekennzeichnet, dass** der Sensorchip (8) sieben Silizium-Driftdetektorzellen (80) umfasst, die jeweils die Form eines gleichseitigen Sechsecks haben, die auf dem Sensorchip (8) mit einer zentralen Silizium-Driftdetektorzelle und sechs waabenförmig darum herum angeordneten Silizium-Driftdetektorzellen angeordnet sind.

23. Röntgendetektormodul nach einem der vorhergehenden Ansprüche, **dadurch gekennzeichnet, dass** die auf den Grundträger in Richtung der zur Ebene des Grundträgers senkrechten Längsachse folgenden Komponenten des Röntgendetektormoduls im Querschnitt senkrecht zur Längsachse nicht über die Außenkontur des Grundträgers hinausragen.

24. Röntgendetektormodul nach Ansprüchen 18 und 23, **dadurch gekennzeichnet, dass** der Sensorkopf und das Kühlrohr (208) im Querschnitt mit der Außenkontur des Grundträgers (2) übereinstimmen und so eine im Querschnitt hexagonale, stiftartige Außenform des Röntgendetektormoduls ergeben.

25. Röntgendetektormodul nach einem der vorhergehenden Ansprüche, **dadurch gekennzeichnet, dass** die Außenkontur des Grundträgers (2) die Form eines gleichseitigen Sechsecks hat.

## Claims

1. An X-ray detector module comprising a plurality of silicon drift detector cells arranged alongside one another on a sensor chip, the sensor chip being accommodated in a cutout of a frame-type basic carrier, such that the sensitive sensor chip surface lies in the opening of the frame-type basic carrier, **characterized in that** a mask (10) is fixed on the side of the basic carrier opposite to the cutout, which mask covers the outer edge regions of outer silicon drift detector cells (80) and projects with ridges (106) above the sensor chip (8) into the opening of the basic carrier (2), the ridges being arranged in such a way that they cover boundary strips of adjacent silicon drift detector cells (80) in order that the outer edge regions and boundary strips covered by the mask (10) are shielded from incident X-ray photons.

2. The X-ray detector module as claimed in claim 1, **characterized in that** the lines required for supplying and reading from the sensor chip (8) are formed by metal tracks (90) on the front and rear sides of the basic carrier (2), required connections between front and rear sides between specific metal tracks being formed by plated-through holes (92) of the basic carrier (2).

3. The X-ray detector module as claimed in claim 1 or 2, **characterized in that** the substrate material of the basic carrier (2) is formed from ceramics based on aluminum or beryllium, in particular Al₂O₃, AlN or BeO₂, preferably AlN.

4. The X-ray detector module as claimed in claim 2 or 3, **characterized in that** the metal tracks (90) are metallic thin-film tracks.

5. The X-ray detector module as claimed in one of the preceding claims, **characterized in that** further ridges are provided in the mask pattern, which cover conductor tracks (84) and transistors (82) in the underlying silicon drift detector cells (80) in order to shield them from incident X-ray photons.

6. The X-ray detector module as claimed in one of the preceding claims, **characterized in that** the mask material has zirconium, titanium, aluminum and/or europium.

7. The X-ray detector module as claimed in claim 6, **characterized in that** the mask material is composed of zirconium and/or ZrO₂.

8. The X-ray detector module as claimed in one of the preceding claims, **characterized in that** the ridges of the mask (10) have a width within the range of 30 to 300 µm, preferably within the range of 75 to 250 µm, in particular within the range of 125 to 175 µm

9. The X-ray detector module as claimed in one of the preceding claims, **characterized in that** a cover (12) covering the sensor chip is fixed on the basic carrier (2) on the side of the sensor chip (8), said cover's side remote from the sensor chip being provided with a cutout which covers the area of the sensor chip in projection and in which a disk-shaped radiation shielding body (14) is arranged.

10. The X-ray detector module as claimed in claim 9, **characterized in that** the cover (12) is produced from Al₂O₃ or AlN, preferably from AlN.

11. The X-ray detector module as claimed in claim 9 or 10, **characterized in that** the radiation shielding body (14) contains tantalum, titanium and optionally aluminum.

12. The X-ray detector module as claimed in one of the preceding claims, **characterized in that** the circuits provided for reading out and amplifying the signals of the silicon drift detector cells (80) are integrated on a circuit chip (20) fixed on one end of an elongate, flexible conductor track carrier (19), which contains the conductor tracks which are provided for supplying and conducting away electrical signals and supply voltages and are connected to the associated connections on the chip, the flexible conductor track carrier being stabilized in the region of the chip (20), on the side opposite to the chip, by fixing on a rigid circuit carrier (18).

13. The X-ray detector module as claimed in claim 12, **characterized in that** the flexible conductor track carrier (19) is formed from a multiplicity of films which are stacked one above another and each carry a plurality of conductor tracks on their surface.

14. The X-ray detector module as claimed in claim 12 or 13, **characterized in that** the circuit carrier (18) lies in a plane parallel to the plane of the sensor chip (20), and **in that** the conductor track carrier (19) is led in a curve of approximately 90° in the region adjoining the circuit carrier in order to lead away from the circuit carrier (18) in a direction essentially perpendicular to the planes of the sensor chip (20) and of said circuit carrier.

15. The X-ray detector module as claimed in one of claims 12 to 14, **characterized in that** line driver circuits (204) are arranged remote from the sensor chip (8) and the circuit chip (20) on the conductor track carrier (19) in order to condition the signals - preamplified in the circuit chip (20) - of the silicon drift detector cells (80) for the further transmission on lines.

16. The X-ray detector module as claimed in one of claims 12 to 15, **characterized in that** the width of the elongate conductor track carrier increases remote from the circuit chip, and **in that** a multiplicity of contact areas are provided in a manner distributed in this widened area (206), each of which contact areas is assigned to a conductor track of the conductor track carrier and is connected to it, and which are in each case connected to a conductor track and to a core that leads into a cable.

17. The X-ray detector module as claimed in claim 16, **characterized in that** the cores of a cable are directly connected to contact areas in the widening region (206) of the conductor track carrier (19) in order thus to provide a plugless cable link.

18. The X-ray detector module as claimed in claim 16 or 17, **characterized in that** the conductor track carrier (19) is bent in tubular fashion in the widening region (206) in order to reduce its increased width extent caused by the widening.

19. The X-ray detector module as claimed in one of the preceding claims, **characterized in that** the mask (10), basic carrier (2), sensor chip (8), cover (12), radiation shield (14), circuit carrier (18), conductor track carrier (19) and circuit chip (20) as sensor head are mounted successively one after another, the cross-sectional form of the sensor head essentially corresponding to the outer contour of the basic carrier (2), the sensor head being fitted to a cooling tube (208) having essentially the same cross-sectional form.

20. The X-ray detector module as claimed in claims 18 and 19, **characterized in that** the tubularly bent widening region (206) of the conductor track carrier bears on the inner wall of the cooling tube (208).

21. The X-ray detector module as claimed in claims 19 or 20, **characterized in that** an interposed piece with a Peltier element (200) for cooling is incorporated between the sensor head and cooling tube (208).

22. The X-ray detector module as claimed in one of the preceding claims, **characterized in that** the sensor chip (8) comprises seven silicon drift detector cells (80) which each have the form of an equilateral hexagon, which are arranged on the sensor chip (8) with a central silicon drift detector cell and six silicon drift detector cells arranged in honeycomb-shaped fashion around the latter.

23. The X-ray detector module as claimed in one of the preceding claims, **characterized in that** the components of the X-ray detector module which follow the basic carrier in a direction of the longitudinal axis perpendicular to the plane of the basic carrier do not project beyond the outer contour of the basic carrier in cross section perpendicular to the longitudinal axis.

24. The X-ray detector module as claimed in claims 18 and 23, **characterized in that** the sensor head and the cooling tube (208) correspond to the outer contour of the basic carrier (2) in cross section and thus produce a cross-sectionally hexagonal, pinlike outer form of the X-ray detector module.

25. The X-ray detector module as claimed in one of the preceding claims, **characterized in that** the outer contour of the basic carrier (2) has the form of an equilateral hexagon.

## Revendications

1. Module de détection de rayons X avec une multitude de cellules de détection de dérive au silicium qui sont placées les unes à côté des autres sur une puce de détection, la puce de détection étant logée dans un évidement d'un support de base en forme de cadre si bien que la surface sensible de la puce de détection se situe dans l'ouverture du support de base en forme de cadre, **caractérisé en ce qu'**un masque (10) est fixé sur le côté du support de base qui est opposé à l'évidement, masque qui recouvre les zones de bord extérieur de cellules de détection de dérive au silicium (80) situées à l'extérieur et qui pénètre avec des barrettes (106) par delà la puce de détection (8) dans l'ouverture du support de base (2), les barrettes étant placées de telle manière qu'elles recouvrent les bandes marginales de cellules de détection de dérive au silicium voisines (80) pour blinder les zones de bord extérieur et les bandes marginales recouvertes par le masque (10) contre l'incidence de photons de rayons X.

2. Module de détection de rayons X selon la revendication 1, **caractérisé en ce que** les lignes nécessaires à l'alimentation et à l'extraction de la puce de détection (8) sont formées par des pistes métalliques (90) sur la face avant et arrière du support de base (2), les connexions requises entre la face avant et arrière étant formées entre certaines pistes métalliques par des métallisations de trous (92) du support de base (2).

3. Module de détection de rayons X selon la revendication 1 ou 2, **caractérisé en ce que** le matériau du substrat du support de base (2) est formé par des céramiques à base d'aluminium ou de béryllium, en particulier de l'Al₂O₃, AlN ou du BeO₂, de préférence de l'AlN.

4. Module de détection de rayons X selon la revendication 2 ou 3, **caractérisé en ce que** les pistes métalliques (90) sont des pistes métalliques à couche mince.

5. Module de détection de rayons X selon l'une des revendications précédentes, **caractérisé en ce que** d'autres barrettes sont prévues dans le dessin de masque qui recouvrent des pistes conductives (84) et des transistors (82) dans les cellules sous-jacentes de détection de dérive au silicium (80) pour les blinder contre l'incidence de photons de rayons X.

6. Module de détection de rayons X selon l'une des revendications précédentes, **caractérisé en ce que** le matériau du masque présente du zirconium, du titane, de l'aluminium et/ou de l'europium.

7. Module de détection de rayons X selon la revendicaton 6, **caractérisé en ce que** le matériau du masque est en zirconium et/ou en ZrO₂.

8. Module de détection de rayons X selon l'une des revendications précédentes, **caractérisé en ce que** les barrettes du masque (10) ont une largeur de l'ordre de 30 à 300 µm, de préférence de l'ordre de 75 à 250 µm, en particulier de l'ordre de 125 à 175 µm.

9. Module de détection de rayons X selon l'une des revendications précédentes, **caractérisé en ce qu'**un couvercle (12) qui recouvre la puce de détection est fixé sur le support de base (2) sur le côté de la puce de détection (8), couvercle dont le côté détourné de la puce de détection est pourvu d'un évidement qui recouvre la surface de la puce de détection en projection dans lequel est placé un corps de blindage antiradiation en forme de disque (14).

10. Module de détection de rayons X selon la revendication 9, **caractérisé en ce que** le couvercle (12) est fabriqué en Al₂O₃ ou AlN, de préférence en AlN.

11. Module de détection de rayons X selon la revendication 9 ou 10, **caractérisé en ce que** le corps de blindage antiradiation (14) contient du tantale, du titane ou en option de l'aluminium.

12. Module de détection de rayons X selon l'une des revendications précédentes, **caractérisé en ce que** les circuits prévus pour l'extraction et le renforcement des signaux des cellules de détection de dérive au silicium (80) sont intégrés sur une puce de circuit (20) qui est fixée sur une extrémité d'un support de piste conductive allongé flexible (19) qui contient les pistes conductives prévues pour l'alimentation et la dérivation de signaux électriques et de tensions d'alimentation qui sont reliées aux raccords correspondants sur la puce, le support flexible de pistes conductives étant stabilisé dans la zone de la puce (20) sur le côté opposé à la puce par la fixation sur un support de circuit rigide (18).

13. Module de détection de rayons X selon la revendication 12, **caractérisé en ce que** le support flexible de pistes conductives (19) est formé par une multitude de feuilles superposées l'une sur l'autre qui portent respectivement une multitude de pistes conductives sur leur surface.

14. Module de détection de rayons X selon la revendication 12 ou 13, **caractérisé en ce que** le support de circuit (18) se situe dans un plan parallèle au plan de la puce de détection (20) et que le support de pistes conductives (19) est guidé dans la zone adjacente au support de circuit dans une courbe d'environ 90° pour continuer dans une direction perpendiculairement aux plans de la puce de détection (20) et du support de circuit (18) à partir de ce dernier.

15. Module de détection de rayons X selon l'une des revendications 12 à 14, **caractérisé en ce que** des circuits d'excitation de ligne (204) sont placés éloignés de la puce de détection (8) et de la puce de circuit (20) sur le support de pistes conductives (19) pour traiter les signaux préamplifiés dans la puce de circuit (20) des cellules de détection de dérive au silicium (80) pour la transmission ultérieure sur des lignes.

16. Module de détection de rayons X selon l'une des revendications 12 à 15, **caractérisé en ce que** la largeur du support de pistes conductives allongé augmente loin de la puce de circuit et qu'il est prévu une multitude de surfaces de contact réparties dans cette surface élargie (206) dont chacune est assignée à une piste conductive du support de pistes conductives et est reliée à celle-ci, le surfaces de contact étant reliées respectivement à une piste conductive et à un brin et le brin allant dans un câble.

17. Module de détection de rayons X selon la revendication 16, **caractérisé en ce que** les brins d'un câble sont reliés directement aux surfaces de contact dans la zone d'élargissement (206) du support de pistes conductives (19) pour créer ainsi une liaison par câble sans connecteur.

18. Module de détection de rayons X selon la revendication 16 ou 17, **caractérisé en ce que** le support de pistes conductives (19) est courbé de forme tubulaire dans la zone d'élargissement (206) pour réduire son extension en largeur agrandie provoquée par l'élargissement.

19. Module de détection de rayons X selon l'une des revendications précédentes, **caractérisé en ce que** le masque (10), le support de base (2), la puce de détection (8), le couvercle (12), le blindage antiradiation (14), le support de circuit (18), le support de pistes conductives (19) et la puce de circuit (20) sont montées en se suivant l'un derrière l'autre comme tête de détecteur, la tête de détecteur étant montée sur un tube de refroidissement (208) avec la même forme de section.

20. Module de détection de rayons X selon les revendications 18 et 19, **caractérisé en ce que** la zone d'élargissement recourbée de forme tubulaire (206) du support de pistes conductives repose sur la paroi intérieure du tube de refroidissement (208).

21. Module de détection de rayons X selon la revendication 19 ou 20, **caractérisé en ce qu'**une pièce intermédiaire avec un élément Peltier (200) pour le refroidissement est monté entre la tête de détecteur et le tube de refroidissement (208).

22. Module de détection de rayons X selon l'une des revendications précédentes, **caractérisé en ce que** la puce de détection (8) comprend sept cellules de détection de dérive au silicium (80) qui ont respectivement la forme d'un hexagone équilatéral qui sont placées sur la puce de détection (8) avec une cellule de détection de dérive au silicium centrale et six cellules de détection de dérive au silicium placées en nid d'abeilles tout autour.

23. Module de détection de rayons X selon l'une des revendications précédentes, **caractérisé en ce que** les composants du module de détection de rayons X suivant sur le support de base en direction de l'axe longitudinal perpendiculaire au plan du support de base en section perpendiculairement par rapport à l'axe longitudinal ne font pas saillie au-delà des contours extérieurs du support de base.

24. Module de détection de rayons X selon les revendications 18 et 23, **caractérisé en ce que** la tête de détecteur et le tube de refroidissement (208) coïncident en section avec les contours extérieurs du support de base (2) et résultent ainsi en une forme extérieure du module de détection de rayons X de type cheville de section hexagonale.

25. Module de détection de rayons X selon l'une des revendications précédentes, **caractérisé en ce que** les contours extérieurs du support de base (2) ont la forme d'un hexagone équilatéral.
